# EUROPEAN PATENT SPECIFICATION

(11) **EP 1 378 933 B1**
(45) Date of publication and mention of the grant of the patent: **08.09.2010**
(21) Application number: 03015016.3
(22) Date of filing: 02.07.2003
(51) Int. Cl.: C23C 14/04, G03F 1/16, H05B 33/10, H01J 9/227

(54) **Shadow mask for fabricating a flat display**
Schattenmaske für die Herstellung eines flachen Displays
Masque perforé pour la fabrication d'un écran plat

(30) Priority: 03.07.2002 KR 2002038347
(43) Date of publication of application: 07.01.2004
(73) Proprietor: LG Display Co., Ltd., Youngdungpo-gu, Seoul (KR)
(72) Inventor: Kim, Chang Nam, Jungnang-gu, Seoul (KR)
(74) Representative: TER MEER - STEINMEISTER & PARTNER GbR

(56) References cited:
- EP-A- 1 209 522
- EP-A- 1 274 130

## Description

### BACKGROUND OF THE INVENTION

### Field of the Invention

The present invention relates to a shadow mask for fabricating a flat display.

### Background of the Related Art

EP 1 274 130 A1 discloses a display panel using a shadow mask for forming the organic luminescence layer, the shadow mask comprising holes and bridges. EP 1 209 522 A2 discloses a mask comprising a main frame with holes and sub-masks fitted therein.

In general, the shadow mask is used in fabricating a full color flat display for forming R, G, B pixels each having good color feeling, and luminous efficiency.

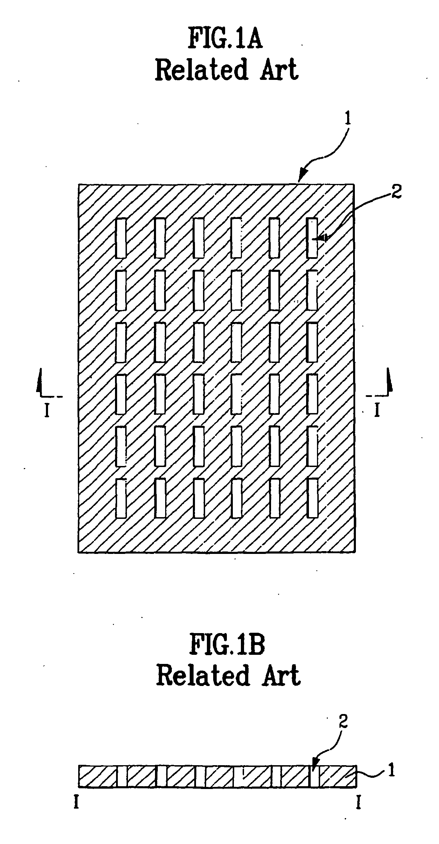

Referring to FIGS. 1A and 1B, the shadow mask used in fabrication of the flat display is provided with a substrate 1, and a plurality of via holes 2 in the substrate 1. The shadow mask may be formed by wet-etching, or electro-forming.

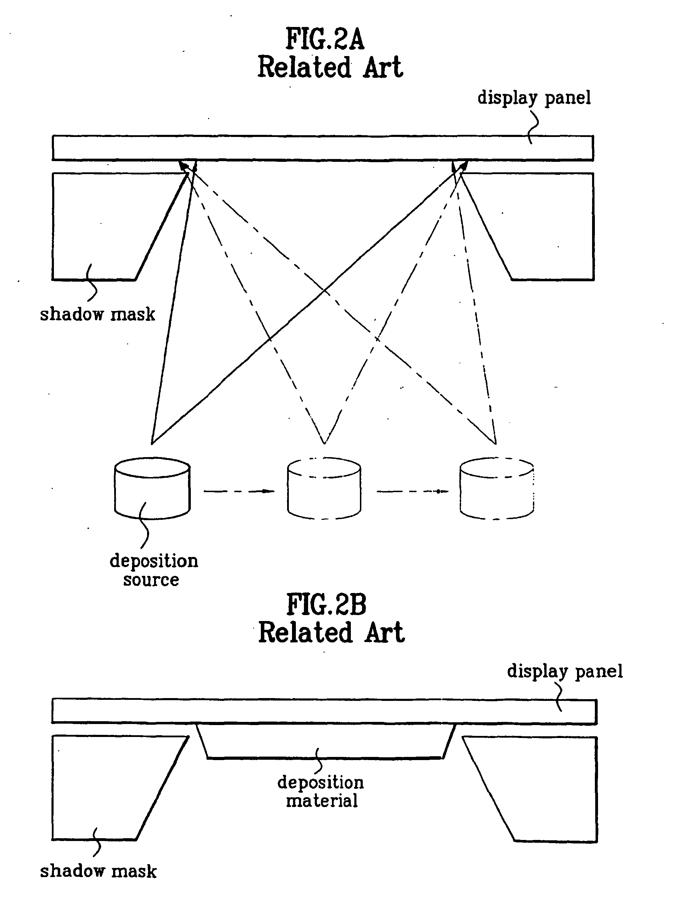

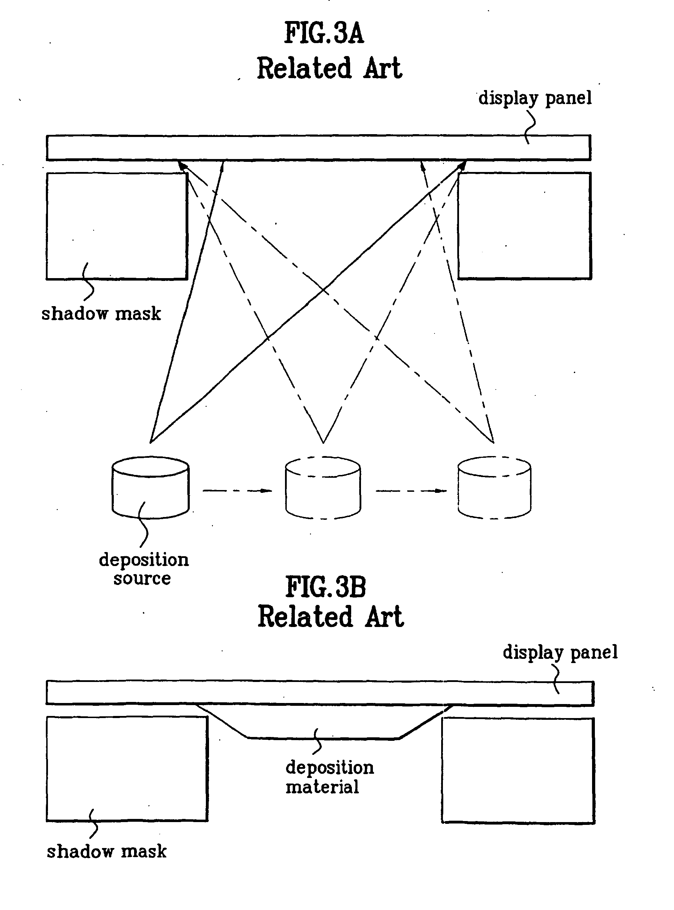

FIGS. 2A and 2B illustrate shadow masks each formed by wet-etching, and FIGS. 3A and 3B illustrate shadow masks each formed by electro-forming.

Referring to FIGS. 2A and 2B, the shadow mask formed by wet-etching has via holes each having a top part size different a bottom part size. That is, the via hole has a sloped sidewall.

However, the shadow mask formed by wet-etching has a great distance between adjacent via holes, which is not suitable for fabrication of a display panel that requires a high precision.

In the meantime, referring to FIGS. 3A and 3B, the shadow mask formed by the electro-forming has via holes each with equal top and bottom part size. That is, the via hole has a vertical sidewall.

However, the shadow mask formed by electro-forming causes to have a shadow phenomenon depending on positions of deposition sources when a material is deposited on a display panel by using the shadow mask.

Referring to FIG. 3B, the shadow phenomenon causes failure in accurate deposition of the material on a desired position of the display panel, which results in nonuniform light emission from the pixel.

### SUMMARY OF THE INVENTION

Accordingly, the present invention is directed to a shadow mask that substantially obviates one or more of the problems due to limitations and disadvantages of the related art.

An object of the present invention is to provide a shadow mask suitable for fabrication of a display that requires a high precision.

Another object of the present invention is to provide a shadow mask having no shadow phenomenon and a high reliability.

Additional advantages of the invention will be set forth in the description which follows, and in part will be apparent to those having ordinary skill in the art upon examination of the following or may be learned from practice of the invention. The objectives and other advantages of the invention will be realized and attained by the structure particularly pointed out in the written description and claims hereof as well as the appended drawings.

To achieve these objects and other advantages a shadow mask according to the present invention comprises the features defined in present claim 1.

Preferable features of a shadow mask of the present invention are defined in present dependent claims 2-15.

### BRIEF DESCRITPION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings;
FIGS. 1A and 1B illustrate a plan view and a section each showing a related art shadow mask, respectively;
FIGS. 2A and 2B illustrate related art shadow masks each formed by wet-etching, respectively;
FIGS. 3A and 3B illustrate related art shadow masks each formed by electro-forming, respectively;
FIGS. 4A and 4B illustrate a plan view and a section each showing a shadow mask in accordance with a preferred embodiment of the present invention, respectively;
FIG. 5A illustrates a via hole of a shadow mask in accordance with a preferred embodiment of the present invention;
FIG. 5B illustrates a bridge formed between adjacent via holes;
FIGS. 6A and 6B illustrate thicknesses of shadow masks, and widths of via holes; and
FIGS. 7A and 7B illustrate deposition of a material with a shadow mask of the present invention.

### DETAILED DESCRIPTION OF THE PREFERRED EMBODIMENT

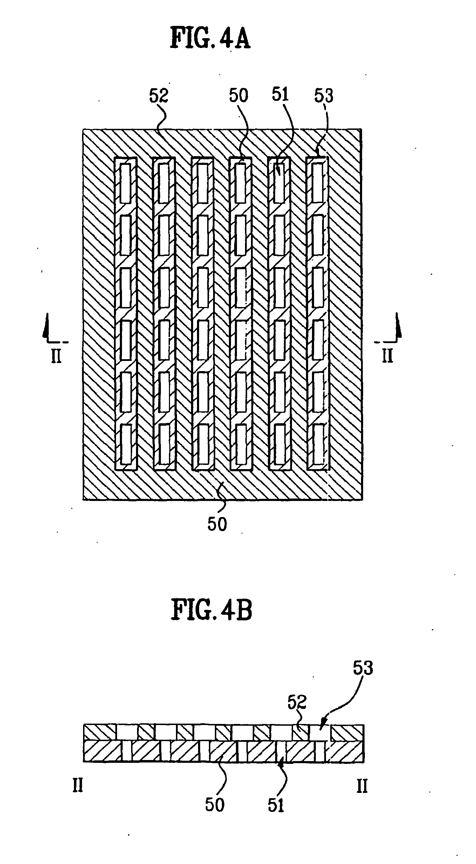

Reference will now be made in detail to the preferred embodiments of the present invention, examples of which are illustrated in the accompanying drawings. FIGS. 4A and 4B illustrate a plan view and a section each showing a shadow mask in accordance with a preferred embodiment of the present invention, respectively.

Referring to FIGS. 4A and 4B, the shadow mask includes a first substrate 50, a plurality of first via holes 51 in the first substrate 50, a second substrate 52 on the first substrate 50, and a plurality of second via holes 53 in the second substrate 52.

The first via holes 51 and the second via holes 53 are arranged, so as to overlap with each other, and a diameter of each of the second via holes 53 is formed to be greater than a diameter of each of the first via holes 51.

The first via hole 51 is rectangular, and a plurality of the first via holes 51 are formed in every column. The second via hole 53 has a form of a stripe formed per every column overlapped with the first via holes 51.

The first, and second via holes 51 and 53 may be formed in a variety of forms, such as circles, polygons, and stripes.

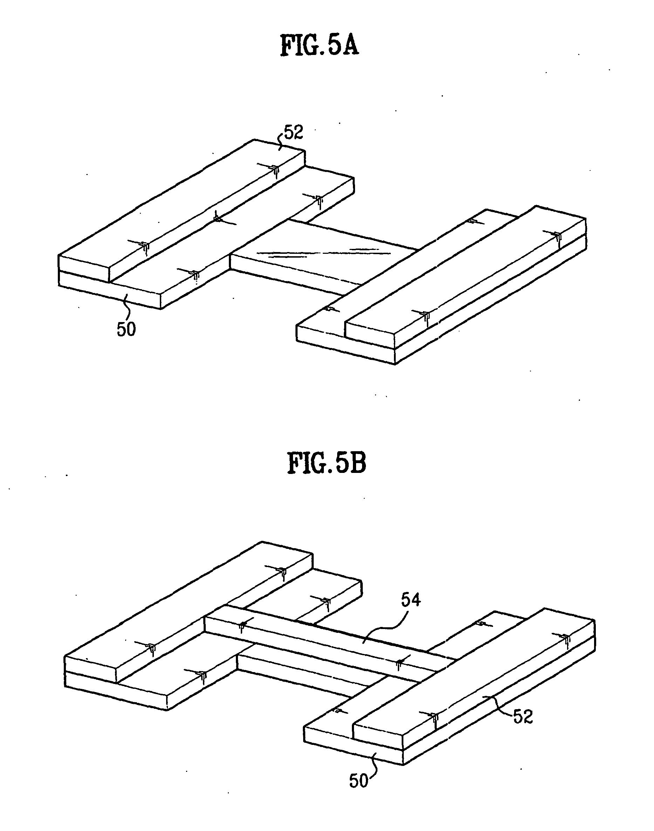

Referring to FIG. 5B, a bridge 54 may be formed on the first substrate 50 between adjacent first via holes 51 additionally, for preventing sagging of the shadow mask. The bridge is formed to have a thickness the same with the second substrate 52 across the second via hole 53.

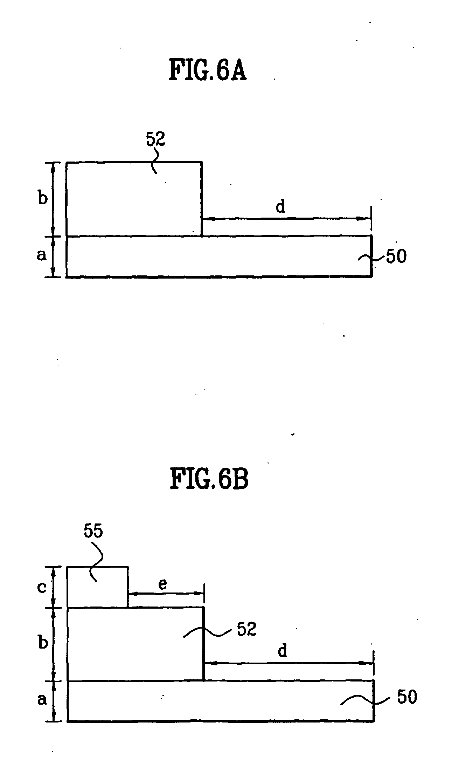

Referring to FIG. 6A, a thickness 'b' of the second substrate 52 is thicker than a thickness 'a' of the first substrate 50. That is, the first substrate 50 is approx. 1 - 100µm thick, and the second substrate 52 is approx. 5 - 1000µm thick. The first via hole 51 and the second via hole 53 have approx. a 1 - 1000µm diametric difference 'd'.

As another embodiment shadow mask of the present invention, a third substrate 55 having a plurality of third via holes can be formed on the second substrate 52 additionally.

In this instance, the third via holes are arranged so as to overlap with the second via hole 53, each with a diameter greater than the diameter of the second via hole 53.

Referring to FIG 6B, the third substrate 55 has a thickness 'c' thinner than the thickness 'b' of the second substrate 52. That is, the thickness 'c' of the third substrate 55 is approx. 1 - 100µm. The diametric difference 'd' between the first and second via holes, or a diametric difference 'e' between the second and third via holes is approx. 1 - 1000µm. A plurality of first via holes are arranged on every column, and one second, or third via hole is arranged on every column.

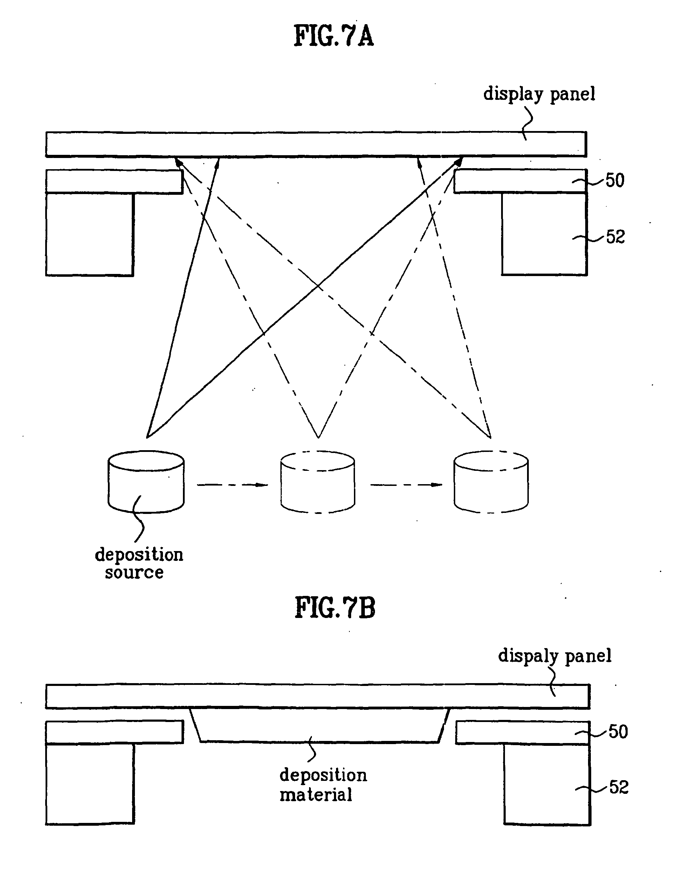

FIGS. 7A and 7B illustrate deposition of a material with a shadow mask of the present invention.

Referring to FIGS. 7A and 7B, when a material is deposited on a display panel with the shadow mask of the present invention, the material can be deposited on an accurate pixel position without the shadow phenomenon.

The shadow mask of the present invention provides a high process reliability as the shadow phenomenon is eliminated, permitting to overcome a drawback of the shadow mask formed by electro-forming. The present invention, employing the electro-forming, is suitable for fabrication of a display that requires a high precision.

It will be apparent to those skilled in the art that various modifications and variations can be made in the present invention within the scope of the invention. Thus, it is intended that the present invention covers the modifications and variations provided they come within the scope of the appended claims.

## Claims

1. A shadow mask for deposition of material on a flat display, the mask comprising a first substrate (50) having a plurality of first via holes (51) formed therein; **characterized in that** the mask further comprises a second substrate (52) positioned on the first substrate (50), the second substrate (52) having a plurality of second via holes (53) formed therein, wherein the first via holes (51) and the second via holes (53) are arranged so as to overlap with each other, and each second via hole (53) has a width greater than a width of a corresponding overlapped first via hole (51).

2. The mask as claimed in claim 1, wherein the thickness of the second substrate (52) is greater than the thickness of the first substrate (50).

3. The mask as claimed in claim 2, wherein the first substrate (50) is 1 - 100µm thick, and the second substrate (52) is 5 - 1000µm thick.

4. The mask as claimed in claim 1, wherein each first via hole (51) and corresponding second via hole (53) have a difference in width of 1 - 1000µm.

5. The mask as claimed in claim 1, wherein the plurality of first via holes (51) are arranged in columns along the first substrate (50), and the plurality of second via holes (53) are arranged on the second substrate (52) such that each column of first via holes (51) is aligned with one corresponding second via hole (53).

6. The mask as claimed in claim 5, wherein the first and second via holes (51, 53) have a form selected from a circle, a polygon, and a stripe.

7. The mask as claimed in claim 1, further comprising a bridge (54) formed on the first substrate (50) between adjacent first via holes (51).

8. The mask as claimed in claim 7, wherein the thickness of the bridge (54) is the same as the thickness of the second substrate (52).

9. The mask as claimed in claim 7, wherein the bridge (54) is configured to cross the corresponding second via hole (53).

10. The mask as claimed in claim 1, further comprising a third substrate (55) provided on the second substrate (52), the third substrate (55) having a plurality of third via holes formed therein, wherein the second via holes (53) and the third via holes are arranged so as to overlap with each other, and a width of each of the third via holes is greater than a width of the corresponding overlapped second via hole (53).

11. The mask as claimed in claim 10, wherein the thickness of the second substrate (52) is greater than the thickness of the third substrate (55).

12. The mask as claimed in claim 11, wherein the third substrate (55) is 1 - 100µm thick.

13. The mask as claimed in claim 10, wherein each second via hole (53) and corresponding third via hole have a difference in width of 1 - 1000µm.

14. The mask as claimed in claim 10, wherein the plurality of third via holes arranged on the third substrate (55) such that each column of the first via holes (51) is arranged with one corresponding third via hole.

15. The mask as claimed in claim 14, wherein the third via holes have forms selected from a circle, a polygon, and a stripe.

## Patentansprüche

1. Schattenmaske für Materialabscheidung auf einem flachen Display, umfassend:
- ein erstes Substrat (50) mit einer Vielzahl von darin ausgebildeten ersten Durchgangslöchern (51);
**dadurch gekennzeichnet, dass** die Maske ferner umfasst:
- ein zweites Substrat (52), das auf dem ersten Substrat (50) angeordnet ist, wobei das zweite Substrat (52) eine Vielzahl von darin ausgebildeten zweiten Durchgangslöchern (53) aufweist, wobei die ersten Durchgangslöcher (51) und die zweiten Durchgangslöcher (53) so angeordnet sind, dass sie miteinander überlappen, und jedes zweite Durchgangsloch (53) eine Weite aufweist, der größer als eine Weite eines entsprechenden überlappten ersten Durchgangslochs (51) ist.

2. Maske nach Anspruch 1, wobei die Dicke des zweiten Substrats (52) größer als die Dicke des ersten Substrats (50) ist.

3. Maske nach Anspruch 2, wobei das erste Substrat (50) 1 µm - 100 µm dick ist und das zweite Substrat (52) 5 µm - 1000 µm dick ist.

4. Maske nach Anspruch 1, wobei jedes erste Durchgangsloch (51) und das entsprechende zweite Durchgangsloch (53) einen Unterschied in der Weite von 1 µm - 1000 µm aufweist.

5. Maske nach Anspruch 1, wobei die Vielzahl von ersten Durchgangslöchern (51) in Spalten entlang des ersten Substrats (50) angeordnet ist und die Vielzahl der zweiten Durchgangslöcher (53) auf dem zweiten Substrat (52) so angeordnet ist, dass jede Spalte von ersten Durchgangslöchern (51) zu einem entsprechenden zweiten Durchgangsloch (53) ausgerichtet ist.

6. Maske nach Anspruch 5, wobei die ersten und zweiten Durchgangslöcher (51, 53) eine Form ausgewählt von einem Kreis, einem Polygon und einem Strich aufweisen.

7. Maske nach Anspruch 1, ferner umfassend:
- eine Brücke (54), die auf dem ersten Substrat (50) zwischen benachbarten ersten Durchgangslöchern (51) ausgebildet ist.

8. Maske nach Anspruch 7, wobei die Dicke der Brücke (54) gleich wie die Dicke des zweiten Substrats (52) ist.

9. Maske nach Anspruch 7, wobei die Brücke (54) so gestaltet ist, dass sie das entsprechende zweite Durchgangsloch (53) schneidet.

10. Maske nach Anspruch 1, ferner umfassend:
- ein drittes Substrat (55), das auf dem zweiten Substrat (52) vorgesehen ist, wobei das dritte Substrat (55) eine Vielzahl von darin ausgebildeten dritten Durchgangslöchern aufweist, wobei die zweiten Durchgangslöcher (53) und die dritten Durchgangslöcher so angeordnet sind, dass sie miteinander überlappen, und eine Weite eines jeden dritten Durchgangslochs größer ist als eine Weite des entsprechenden überlappten zweiten Durchgangslochs (53).

11. Maske nach Anspruch 10, wobei die Dicke des zweiten Substrats (52) größer ist als die Dicke des dritten Substrats (55).

12. Maske nach Anspruch 11, wobei das dritte Substrat (55) 1 µm - 100 µm dick ist.

13. Maske nach Anspruch 10, wobei jedes zweite Durchgangsloch (53) und das entsprechende dritte Durchgangsloch einen Unterschied in der Weite von 1 µm - 1000 µm aufweist.

14. Maske nach Anspruch 10, wobei die Vielzahl von dritten Durchgangslöchern auf dem dritten Substrat (55) so angeordnet ist, dass jede Spalte der ersten Durchgangslöcher (51) zu einem entsprechenden dritten Durchgangsloch ausgerichtet ist.

15. Maske nach Anspruch 14, wobei die dritten Durchgangslöcher Formen ausgewählt von einem Kreis, einem Polygon und einem Strich aufweisen.

## Revendications

1. Masque à trous pour la déposition d'un matériau sur un écran plat, le masque comprenant un premier substrat (50) ayant une pluralité de premiers trous traversants (51) formés à l'intérieur ;
**caractérisé en ce que** le masque comprend encore un second substrat (52) positionné sur le premier substrat (50), le second substrat (52) ayant une pluralité de seconds trous traversants (53) formés à l'intérieur, tels que les premiers trous traversants (51) et les seconds trous traversants (53) sont agencés de manière à se chevaucher les uns les autres, et chaque second trou traversant (53) a une largeur supérieure à une largeur d'un premier trou traversant correspondant (51) en chevauchement.

2. Masque selon la revendication 1, dans lequel l'épaisseur du second substrat (52) est supérieure à l'épaisseur du premier substrat (50).

3. Masque selon la revendication 2, dans lequel le premier substrat (50) a une épaisseur de 1 à 100 µm, et le second substrat (52) a une épaisseur de 5 à 1000 µm.

4. Masque selon la revendication 1, dans lequel chaque premier trou traversant (51) et chaque second trou traversant correspondant (53) ont une différence de largeur de 1 à 1000 µm.

5. Masque selon la revendication 1, dans lequel la pluralité de premiers trous traversants (51) sont agencés en colonnes le long du premier substrat (50), et la pluralité de seconds trous traversants (53) sont agencés sur le second substrat (52) de telle façon que chaque colonne de premiers trous traversants (51) est alignée avec un second trou traversant correspondant (53).

6. Masque selon la revendication 5, dans lequel les premiers et les seconds trous traversants (51, 53) ont une forme choisie parmi un cercle, un polygone et un ruban.

7. Masque selon la revendication 1, comprenant en outre un pont (54) formés sur le premier substrat (50) entre des premiers trous traversants adjacents (51).

8. Masque selon la revendication 7, dans lequel l'épaisseur du pont (54) est la même que l'épaisseur du second substrat (52).

9. Masque selon la revendication 7, dans lequel le pont (54) est configuré pour croiser le second trou traversant correspondant (53).

10. Masque selon la revendication 1, comprenant en outre un troisième substrat (55) prévu sur le second substrat (52), le troisième substrat (55) ayant une pluralité de troisièmes trous traversants formés à l'intérieur, tels que les seconds trous traversants (53) et les troisièmes trous traversants sont agencés de manière à se chevaucher les uns les autres, et une largeur de chaque troisième trou traversant est supérieure à une largeur d'un second trou traversant correspondant (53) en chevauchement.

11. Masque selon la revendication 10, dans lequel l'épaisseur du second substrat (52) est supérieure à l'épaisseur du troisième substrat (55).

12. Masque selon la revendication 11, dans lequel le troisième substrat (55) a une épaisseur de 1 à 100 µm.

13. Masque selon la revendication 10, dans lequel chaque second trou traversant (53) et chaque troisième trou traversant correspondant ont une différence de largeur de 1 à 1000 µm.

14. Masque selon la revendication 10, dans lequel la pluralité de troisièmes trous traversants sont agencés sur le troisième substrat (55) de telle manière que chaque colonne de premiers trous traversants (51) est agencée avec un troisième trou traversant correspondant.

15. Masque selon la revendication 14, dans lequel les troisièmes trous traversants ont des formes choisies parmi un cercle, un polygone et un ruban.
